Europäisches Patentamt

European Patent Office

Office européen des brevets

(19)

(11) Publication number: **0 397 532**
**A2**

# EUROPEAN PATENT APPLICATION

(21) Application number: **90305129.0**

(22) Date of filing: **11.05.90**

(51) Int. Cl.⁵: **G06F 15/60**

(30) Priority: **12.05.89 GB 8910965**

(43) Date of publication of application:
**14.11.90 Bulletin 90/46**

(84) Designated Contracting States:
**DE FR GB**

(71) Applicant: **GENRAD, INC.**
**300 Baker Avenue**
**Concord Massachusetts 01742-2174(US)**

(72) Inventor: **Colley, John Larry**
**16 Monarch Close, Locks Road**
**Locks Heath, Southampton SO3 6UG(GB)**
Inventor: **Kilty, Paul François**
**67 Solent View Road**
**Seaview, Isle of Wight PO 34 5HH(GB)**

(74) Representative: **Sturt, Clifford Mark et al**
**MARKS & CLERK 57-60 Lincoln's Inn Fields**
**London WC2A 3LS(GB)**

(54) Simulation system.

(57) A system and method for simulating the operation of electronic circuits. In one arrangement the system includes memory means having stored therein a gate primitive comprising three elements each containing data respectively ooncerning the functionality, input/output propogation delays and timing checks of the gate. In another arrangement, the system includes memory means having stored therein a gate primitive containing data concerning the functionality of the gate with said data being stored in a decision tree data structure. In a further arrangement, the system includes memory means having stored therein a gate primitive containing data stored in accordance with different states of operation of the gate.

EP 0 397 532 A2

## Simulation system

The present invention relates to a system and method for simulating the operation of electronic circuits, such circuits comprising a plurality of components or, for example, a single semiconductor device.

It is well known to use simulation techniques to assist in the design, verification and testing of electronic circuits. Such circuit simulation is often developed from simulation of the operation of a number of basic circuit elements - for example, individual logic gates such as AND gates, flip-flops and the like. Hereinafter the expression 'gate' will be used to denote any such basic circuit element. Conventionally, the operation of a gate is often represented by a truth table. Truth tables specify the expected output of the gate in accordance with various inputs applied thereto. It is known to use a digitally encoded form of truth table in a simulation system. This is often referred to as the gate 'primitive'. However, a simple truth table contains insufficient information for realistic simulation of the operation of an actual circuit. For example, the truth table includes no information concerning propogation delays between the application of an input and the generation of an output (Input output or so called "pin-to-pin" delays). In known simulation systems this information is included in the digitally stored version of the truth table. Another factor to be considered is the timing of the input signals, for example whether the signal is input just prior to or just after a clock signal. Traditionally these considerations have been dealt with by the provision of a separate model associated with the input signals, before the signals are applied to the model of the gate itself. This has, however, resulted in performance degradation of the simulation system.

It is the general object of the present invention to provide an improved simulation system.

According to a first aspect of the present invention there is provided a simulation system for simultating the operation of a gate, including memory means having stored therein a gate primitive comprising three elements each containing data respectively concerning the functionality, input/output propogation delays and timing checks of the gate.

According to a second aspect of the present invention there is provided a simulation system for simulating the operation of a gate, including memory means having stored therein a gate primitive containing data concerning the functionality of the gate with said data being stored in a decision tree data structure.

According to a third aspect of the invention there is provided a simulation system for simulating the operation of a gate, including memory means having stored therein a gate primitive containing data stored in accordance with different states of operation of the gate.

An embodiment of the present invention will now be described in detail by way of example only.

The present invention provides a unified gate primitive comprising three elements respectively relating to functionality, propogation delay and timing checks. Unlike conventional arrangements, the basic truth table is fully expanded so as to avoid the occurrence of 'unknown' outputs. This provides a level of accuracy not previously obtained. At the same time, the present invention uses significantly less memory space and operates substantially faster than prior arrangements. These benefits accrue from the unified gate primitive and the particular manner in which the elements are implemented.

Processing of the initial truth table data involves the creation of a different from of data structure. Specifically, instead of the conventional straightforward digital storage of the truth table, the table is used to generate a decision tree. It is the data structure of the decision tree which is stored. This conversion of the data structure enables significant advantages to be gained during subsequent operation of the simulation system and is also responsible for a significant saving in memory space requirements. The memory space saving largely results from the quadratic implications of the decision tree representation, which enables a compact form of representation to be used.

Use of the decision tree data structure provides further important advantages in comparison with use of the truth table data structure. In particular, the decision tree data structure enables retention of information concerning the nature of the inputs to the gate. A truth table is homogeneous, giving the resultant output but losing information concerning the input. The decision tree structure can be used to establish precedents as to how various inputs should be processed. That is, the decision tree structure can establish which are the more important inputs.

In a conventional truth table some outputs must be designated as being unkown because, for example, the output depends upon the sequence of the inputs. Dealing with such outputs is often referred to as 'X' handling and this normally requires ad hoc processing which results in performance degradation. The decision tree structure provides automatic 'X' handling thereby gaining corresponding improvements in performance. Automatic 'X' handling can be achieved because the tree structure contains more information than the simple look-up array of a truth table. The decision tree retains knowledge of the way in which the inputs have changed and this enables the 'X' output to be deduced with considerable accuracy. This is of particular importance for sequential devices, where the order of the input changes is of crucial importance.

Knowledge concerning the sequence of inputs involves more than simply recording which input occurred before another. It is important to consider when a particular input occured in relation to the clock signal of the gate. The real gate may well produce different outputs dependent upon such timings. If so, the simulation must accurately reproduce such operation. A further example of such considerations concerns operation of the gate when inputs occur simultaneously. Conventional simulation systems have difficulty in dealing with such circumstances, which again results in performance degradation. The decision tree data structure significantly facilitates simulation of gate operation under these conditions.

In general, the simulation system of the present invention re-organises the simulation processing tasks so that a large portion of the processing is undertaken in advance of the 'real time' simulation of the gate operation. Run-time processing is reduced. These benefits are obtained without incurring the processing time and memory requirements which would be involved in simply 'number crunching' the truth table data to encode an array detailing all outputs of the gate.

One of the main features of the present invention is that the functionality element of the gate primitive is encoded in the form of 'state' information. That is, the stored data relates to the state of operation of the gate - it keeps track of operation of the gate. Simulation of gate operation proceeds by working 'down' the tree data structure. Because the data is encoded so as to keep note of the 'state' of the gate, subsequent processing steps work from the previous evaluation point on the tree. That is, each processing step does not restart from the top of the tree.

The data structure of the decision tree can be arranged in accordance with 'higher' precedence inputs and 'lower' precedence inputs. Higher precedence inputs are inputs which tend to change infrequently; for example, enabling signals. Lower precedence inputs are inputs which tend to change frequently; for example, clock signals. The tree structure can also reflect the fact that it is far more frequent for a gate to be in the enabled state when clocked than in the disabled state. Thus, the data encoded for the enabled state is used more frequently that that for the disabled state. It is therefore more convenient for the simulation process to access data pre-calculated on the basis of the gate being enabled rather than incur such calculation at run-time. Such arrangement of the data structure provides enhanced processing speeds. The data encoded in this element can specify processing functions, such as deferment of calculation of the consequences of simultaneous inputs.


TRANSLATING THE TRUTH TABLE INTO A DECISON TREE

A decision tree is built from three-valued trinodes which have an entry representing each of the logic values 0, 1, and X (unknown)

Each level in the tree represents an input to the primitive. Each row of the input truth table is represented by a unique path down the tree. The branches of the tree are terminated by output records.

Consider a two-input device having the following truth table :-

| i1 | i2 | out |
|----|----|-----|
| 0 | ? | 1 |
| 1 | 0 | 1 |
| 1 | 1 | 0 |

where "?" represents "don't care".

The rows of the table are processed in order, the first row creating the following subtree :-

```
              X    1    0
          +----------+
i1 ..........    :    :    : * :
          +----------+-+
                     :
                     :           +----------+
          +---------(1)-+  out = 1 :
                     +----------+
```

The second row augments the tree thus :-

```
              X    1    0
          +----------+
i1 ..........    :    : * : * :
          +----+---+-+
                :    `:
                :    :           +----------+
                :    +--------(1)-+  out = 1   :
                :                 +----------+
                :
                V

              X    1    0
          +----------+
i2 ..........    :    :    : * :
          +----------+-+
                     :
                     :           +----------+
          +--------(2)-+  out = 1   :
                     +----------+
```

The information from the third row is introduced to complete the tree :-

```
            X    1    0
          +-----------+
i1 .........  :   :  * :  * :
          +-----+---+-+
              :      :
              :      :          +-----------+
              :      +--------(1)-+  out = 1  :
              :                   +-----------+
              :
              :
              V

            X    1    0
          +-----------+
i2 .........  :   :  * :  * :
          +-----+---+-+
              :      :
              :      :          +-----------+
              :      +--------(2)-+  out = 1  :
              :                   +-----------+
              :
              :
              :
              :
              :
              :
              :                  +-----------+
              +----------(3)-+  out = 0  :
                               +-----------+
```

The out records labelled (1), (2), (3) represent the resulting output value when the values on the inputs i1 and i2 are unambiguous, (ie. 0 or 1).

The process for building the 0/1 tree may be represented thus :-

```
                    +-----------+
                    :   START   :
                    +-----+-----+
                          :
                          :
                          :
                          :
                          :
                          :
                          :
                          :
              +-----------------+
              : Read row from   :
              :  truth table    :<------------+
              +--------+--------+              :
                       :                       :
                       :                       :
                       :                       :
                       :                       :
            +-------------------+              :
            : Insert row data   :              :
            :    into tree      :              :
            +--------+--------+                :
                     :                         :
                     :                         :
                     :                         :
                     :                         :
            +-----------------+      YES       :
            :   more rows in  +------------->+
            :     table?      :
            +--------+--------+
                     :
                     :
                     :
                     :
                     :  NO
                     :
                     V
              +----+-----+
              :  FINISH  :
              +----------+
```

AUTOMATIC X HANDLING

Once the fundamental 0/1 tree has been built from the truth table, the tree is augmented to take care of the unknown (X) states.

The automatic X handling algorithm applies the function "same" to each trinode in the tree recursively.

The algorithm handles essentially three distinct cases :-

1. Both the "0" and "1" entries in the trinode point to output records (ie "b" and "c" both represent "leaves" in the decision tree): -

```
                            X    1    0
                          +-----------+
        in ..........     : a : b : c :
                          +-----+---+-+
                               :     :
                               :     :                   +-----------+
                               :     +---------(1)-+  out = 1 :
                               :        .          +-----------+
                               :
                               :
                               :
                               :
                               :
                               :
                               :                   +-----------+
                               +---------(2)-+  out = 0 :
                                                   +-----------+
```

In this case same (a, b, c) may be described thus :-

(i) Create a list which represents the set of output records pointed to by "b" and "c".

(ii) Make "a" point to this list.

```
                            X    1    0
                          +-----------+
        in ..........     : a : b : c :
                          +-+---+---+-+
                            :   :   :
                            :   :   :                 +-----------+
                            :   :   +---------(1)-+  out = 1 :
                            :   :                     +-----------+
                            :   :
                            :   :
                            :   :                     +-----------+
                            :   +-----------(2)-+  out = 0 :
                            :                         +-----------+
                            :
                            :
                            :
                            :
                            :                 +-----+     +-----+
                            +-----------+ (1) +----+ (2) :
                                          +-----+     +-----+
```

If "b" or "c' already point to a "same" list, then the new list is formed from the union of the same list(s) and output record number(s).

2. Neither of the "O" or "1" entries are leaves :-

```
                                      X     1    0
                                      +-----------+
        i1 .........               :  a :  b :  c :
                                      +----+---+-+
                                           :       :
                                           :       :
                                           :       +----------------+
                                           :                        :
                                           :                        :
                                           :                        :
                                           V                        V
                                      X    1    0               X    1    0
                                      +----------+              +----------+
        i2 ..........             :  d :  e :  f :           :  g :  h :  i :
                                      +----------+              +----------+
```

same (a, b, c) is equivalent to :-
same (d, e, f )
same (g, h, i )
Create new trinode (j, k, 1) and make "a" point to it.
same (k, e, h)
same (l, f, i)
same (j, k, l)

```
                                      X     1    0
                                      +----------+
        i1 ..........             :  a :  b :  c :
                                      +-+--+---+-+
                                        :    :    :
                                        :    :    :
            +-----------------+         :    +---------------+
            :                          :                    :
            :                          :                    :
            V                          V                    V
        X    1    0                X    1    0            Z    1    0
        +----------+               +----------+           +----------+
     :  j :  k :  1 :           :  d :  e :  f :        :  g :  h :  i :
        +----------+               +----------+           +----------+
```

3. One of the "O" or "1" entries are leaves (eg "c" ):-

8

```
                                           X    1    0
                                         +-----------+
        i1 . . . . . . . . .             : a : b : c :
                                         +----+---+-+
                                              :
                                              :
                                              :
                                              :
                                              :
                                              :
                                              V

                                           X    1    0
                                         +-----------+
           i2 . . . . . . . . .          : d : e : f :
                                         +-----------+
```

same (a, b, c) is equivalent to :-
same (d, e, f)
create new trinode (g, h, i) and make "a" point to it.
same (h, e, c)
same (i, f, c)
same (g, h, i)

```
                                  `             X    1    O
                                             +-----------+
           i1 . . . . . . . . .              : a : b : c :
                                             +-+---+-----+
                                              :    . :
              +-------------------+           :      :
              :                   :           :      :
              :                   :           :      :
              :                   :           :      :
              V                   V
           X    1    0          X    1    0
         +-----------+        +-----------+
         : g : h : i :        : d : e : f :
         +-----------+        +-----------+
```

The process for augmenting the decision tree for automatic X handling may be represented thus :-

```
              +---------------+
              :     START     :
              : same( x, y, z):
              +-------+-------+
                      :
                      :
                      :
                      :
                      :
              +-------+-------+                        +------------------+
              :     both      :        YES             :   create list    :
              :  y and z are  +-------------------->+   :    and make      :
              :    leaves?    :                        :  node "x" point   :
              +---------------+                        :      to it        :
                      :                                +--------+---------:
                      : NO                                      :
                      :                                         :
              +-------+-------+        YES                       :
              :  y is a leaf? :------------->+             +----+----+
              +-------+-------+              :             : FINISH  :
                      :                      :             +---------+
                      : NO                   :
                      :                      :
              +-------+-------+              :
              : recall "same" :             :
              :  for trinode  :             :
              : pointed to by :             :
              :       Y       :             :
              +-------+-------+             :
                      :                      :
                      :     +<---------------------+
                '     +<---------------------+
                      :
```

```
                      :
         +-------+--------+            YES
         :  z is a leaf?  : -------------->+
         +-------+--------+                :
                 :                         :
                 :  NO                     :
                 :                         :
         +-------+--------+                :
         :  recall "same" :               :
         :   for trinode  :               :
         :  pointed to by :               :
         :        z       :               :
         +-------+--------:               :
                 :                        :
                 :                        :
         +<--------------------------+
                 :
                 :
         +-------+---------+
         :   create new    :
         :     trinode     :
         :   and make x    :
         :   point to it   :
         +-------+---------+
                 :
         +-------+---------+
         :  recall  "same" :
         :   for trinode   :
         :  comprising the :
         :   "1" entries   :
         :  of the trinodes :
         :   pointed to by :
         :     x, y and z  :
         +-------+---------+
                 :
                 :
         +-------+---------+
         :  recall "same"  :
         :   for trinode   :
         :  comprising the :
         :   "O" entries   :
         :  of the trinodes :
         :  pointed to by  :
         :   x, y, and z   :
         +-------+---------+
                 :
                 :
         +-------+---------+
         :  recall "same"  :
         :   for trinode   :
         :  pointed to by  :
         :        x        :
         +-----------------+
```

11

The decision tree for the two-input device described above is fully expanded thus :-

```
                                        X    1    0
                                        +-----------+
   i1 . . . . . . . . . .               :  * :  * :  * :
                                        +-+---+---+-+
                                          :    :    :
                                          :    :    :           +----------+
            +------------------+          :    : ---(1)-+  out = 1  :
            :                  +          :                +----------+
            :                             :
            V                             V
            X    1    0                   X    1    0
            +-----------+                 +-----------+
   i2    :  * :  * :  * :                 :  * :  * :  * :
            +-+---+---+-+                 +-+---+---+-+
            :    :    :                   :    :    :
            :    :    :                   :    :    :           +----------+
            :    :    :                   :    :  +--(2)-+  out = 1  :
            :    :    :                   :    :                +----------+
            :    :    :                   :    :
            :    :    :                   :    :
            :    :    :                   :    :
            :    :    :                   :    :           +----------+
            :    :    :                   :    +------(3)-+  out = 0  :
            :    :    :                   :                +----------+
            :    :    :                   :
            :    :    :                   :         +-----+      +-----+
            :    :    :                   +---------+ (2) +----+ (3) :
            :    :    :                             +-----+      +-----+
            :    :    :
            :    :    :                             +-----+      +-----+
            :    :    +-------------------------------+ (2) +----+ (1) :
            :    :                                    +-----+      +-----+
            :    :
            :    :                             +-----+      +-----+
            :    +------------------------------+ (3) +----+ (1) :
            :                                    +-----+      +-----+
            :
            :                   +-----+      +-----+      +-----+
            +---------------------+ (1) +----+ (2) +----+ (3) :
                                +-----+      +-----+      +-----+
```

Storage of data in terms of state information, by the funotionality element of the gate primitive, enables the processing controlled by the other two elements of the primitive to be effected in a very efficient and convenient manner.

The propogation delay element of the primitive will now be described.

As already mentioned, this element is concerned with the delays in signal propogation which occur internally of the gate - the so called 'pin-to-pin' delay. This information is conventionally stored together with the functionality information in a single element which constitutes the whole of the gate primitive. In the present arrangement, the pin-to-pin delay data is stored as a separate element - that is, as one of the three constituent elements of the gate primitive. Furthermore, in the present arrangement the pin-to-pin delay data is encoded in state dependent form. That is, the element specifies pin-to-pin timing delays for each 'state' of the gate's operation. The basic information is encoded from the data specifications of the gate concerned, but whereas this information would conventionally be encoded directly, in the present arrangement the information is converted to state dependent form and is then encoded. This results in improved processing performance. The full input data need not always be input to derive the required pin-to-pin delay. Instead, processing is improved by deriving the required data by specifying the appropriate change of state.

Pin-to-pin delay data encoded in the element preferably extends beyond a consideration of the delays incurred strictly within the gate. This is beneficial when the outputs of the gate are unbuffered. Any capacitance associated with the external circuit connected to the unbuffered output can be considered to affect the pin-to-pin delay. In simulating such behaviour, use can be made of a multiplication factor which is applied to the internal pin-to-pin delay. Where several capacative influences affect a single output the respective multiplication factors can be summed. It is to be noted that the multiplication factors may differ according to the change of state involved. For example, the multiplication factor for a specified output may well differ in dependence upon the output transition being high-to-low or low-to-high.

## EXAMPLE OF TIMINGS

| TIMINGS | | | | | |
|---|---|---|---|---|---|
| * | from | to | delay | q__marginal | Nq__marginal |
| 1 | clock(0-1) | q(O-1) | clock__q__th | marg__mh | d__zero, |
| 1 | clock(0-1) | q(1-0) | clock__q__tl | marg__ml | d__zero, |
| 1 | clock(0-1) | Nq(0-1) | clock__nq__th | marg__ml | marg__mh |
| 1 | clock(0-1) | Nq(1-0) | clock__nq__tl | marg__mh | marg__ml |
| 2 | Nset(1-0) | q | set__q__th | marg__mh | d__zero, |
| 2 | Nset(1-0) | Nq | set__nq__tl | marg__mh | marg__ml, |
| 2 | Nr(1-0) | q | reset__q__tl | marg__ml | d-zero, |
| 2 | Nr(1-0) | Nq | reset__nq__th | marg__ml | marg__mh |

*where state 1 is S__ENABLE and state 2 is S__LEVEL

For example in state S__ENABLE the delay from clock rising to the transition of Nq from 0 to 1 is :-
clock__nq__th + marg__ml * capacitance(q) +
marg__mh * capacitance(Nq)

The timing check element of the unified gate primitive will now be described.

As already mentioned, conventionally timing checks have been dealt with by means of processing a separate model distinct from the gate primitive. In the present arrangement timing check data forms the third of the constituent elements of the gate primitive. Typically a timing check might be concerned with a gate requirement for input changes to occur in sufficient time before application of the clock pulse. If an input pulse stradles the start of the clock pulse, the input pulse may fail to cause a reaction within the gate - unless the input pulse is 'held' for a prolonged period. Thus a conventional timing check model might typically designate an input signal as 'set-up' , 'steady' or 'hold' - dependent upon its temporal relationship with the clock signal. In contrast, the present arrangement operates on the concept of a 'delta' time - which is the time difference between the leading edge of the input signal and the leading edge of the adjacent clock pulse. Datum points other than the leading edges may be used, if desired.

The present arrangement provides for maximum and mimimun delta times to be specified for each input terminal or input signal, or classes thereof. As in the other two elements, data is encoded in this element in terms of 'state' information with the consequential performance improvements described above. Moreover, the timing check element stores information concerning the conditions under which the delta times may change - thus enabling the generation of warning messages; for example if the gate is being driven too fast. The delta-time concept enables the timing check element to achieve a broad generality with consequential improvements in performance and memory requirements.

A special benefit of inclusion of the timing check element in the gate primitive, in contrast to the use of a separate model, is that individual timing checks can be switched on/off at run-time. Conventionally, any such change would necessitate recompilation of the timing check model.

EXAMPLE OF TIMECHECKS

| TIMECHECKS | | | | |
|---|---|---|---|---|
| * | from | to | condition | message |
| 1 | data | clock(0-1) | <data_setup | data_setup_m, |
| 1 | clock(0-1) | data | <data_hold | data_hold_m, |
| 2 | Nset(0-1) | clock(0-1) | <set_release | set_release_m, |
| 2 | Nr(0-1) | clock(0-1) | <reset_release | reset_release_m, |

* where state 1 is S_ENABLE and state 2 is S_LEVEL

For example if the time difference between data changing and the clock rising, in state S_ENABLE, is less than the parameter data_setup a violation message is generated.

An optional feature which can be added to the above described gate primitive relates to fault simulation.

The above description is concerned with simulation of the behaviour of the gate assuming the application of fault-free inputs. Fault simulation is concerned with simulating operation of the gate when the inputs to the gate are not fault-free. This is achieved in the present arrangement by associating a value with each input of the gate representative of a fault-free input thereto. Subsequently, a list of values is derived for the input. Each value in the list corresponds to a particular fault which would occur in the circuit generating the input signal. It has been found that various faults in the input generating circuit can be grouped together in accordance with the effect which the faults have upon the gate. It is thus possible to use a single fault value to represent a group of input circuit faults, thereby reducing the storage and processing requirements for implementing a full fault simulation option. This enables the functionality, pin-to-pin delay and timing check elements to be applied to fault simulation.

In summary, the present arrangement involves the use of a unified gate primitive having three constituent elements. These three elements relate to functionality, propagation or pin-to-pin delay, and timing checks. Each element is organised on the basis of 'state' related information and a decision tree data structure is used. A fault simulation option may be added to the primitive and this may beneficailly employ a fault grouping regime. It is to be understood that a library of gate primitives may be used to implement simulation of an individual component, such as an integrated circuit, or electronic system.

One embodiment of the invention has been described in detail. It will be readily apparent to those skilled in the art that various modifications may be made and other embodiments implemented without departing from the scope of the inventive concept.

## Claims

1. A simulation system for simultating the operation of a gate, including memory means having stored therein a gate primitive comprising three elements each containing data respectively concerning the functionality, input/output propogation delays and timing checks of the gate.

2. A simulation system as claimed in claim 1, wherein the elements containing data concerning the functionality of the gate has a decision tree data structure.

3. A simulation system as claimed in any preceding claim, wherein the data concerning the functionality of the gate contains data which identifies the sequence of inputs to the gate with respect to one another or wherein the data concerning the functionality of the gate contains data which identifies sequence of inputs to the gate with respect to clock pulses applied to the gate.

4. A simulation system as claimed in any preceding claim, wherein the gate has at least two inputs and an output and the functionality element of the primitive contains data which provides an output value when one input value is unknown.

5. A simulation system as claimed in any preceding claim, wherein the functionality element of the primitive contains data which identifies a processing function to be undertaken when a specific sequence of events occur.

6. A simulation system as claimed in claim 1, wherein the data stored in at least one of: the functionality element, the propogation delay element and the timing check element of the primitive is stored in accordance with different states of operation of the gate.

7. A method of simulating the operation of a gate, oomprising the formation of a gate primitive having three elements each containing data respectively concerning the functionality, input/output propogation delays and timing checks of the gate.

8. A method as claimed in claim 7, wherein formation of the functionality element of the primitive includes the conversion from a truth table data structure to a decision tree data structure.

9. A method as claimed in claim 8, wherein the said conversion is undertaken by sequentially processing the rows of the table.

10. A method as claimed in any of claims 7 to 9, further comprising the step of generating and storing data providing an output value when one of a plurality of input values is unknown by applying the "same" function.